# EUROPEAN PATENT APPLICATION

(11) **EP 4 811 942 A1**
(43) Date of publication of application: **23.09.2026**
(21) Application number: 24889939.5
(22) Date of filing: 14.03.2024
(51) Int. Cl.: H05K 7/20

(54) **INVERTER AND HEAT DISSIPATION STRUCTURE THEREOF**

(30) Priority: 16.11.2023 CN 202323132153 U
(71) Applicant: Sungrow Power Supply Co., Ltd., Hefei, Anhui 230088 (CN)
(72) Inventor: TAN, Jun, Hefei, Anhui 230088 (CN); ZHENG, Hao, Hefei, Anhui 230088 (CN); SHU, Wentao, Hefei, Anhui 230088 (CN); WANG, Xiaohu, Hefei, Anhui 230088 (CN)
(74) Representative: Epping - Hermann - Fischer
(86) International application number: PCT/CN2024/081618
(87) International publication number: WO 2025/102565

(57) **Abstract**

Disclosed in the present application are an inverter and a heat dissipation structure thereof. The heat dissipation structure of an inverter comprises: a first cabinet, a second cabinet, a liquid-cooling radiator and a first liquid-cooling heat exchanger, wherein the first cabinet comprises an electronic cavity; the liquid-cooling radiator is configured to perform heat dissipation on a power module of an inverter power module part, and a cooling liquid channel of the liquid-cooling radiator is in communication with a cooling liquid channel of the first liquid-cooling heat exchanger; the heat dissipation structure of an inverter is provided with a heat dissipation cavity, which is configured to allow air to flow through, so as to cool a cooling liquid in the first liquid-cooling heat exchanger; and the second cabinet comprises a direct-current power distribution cavity, an alternating-current power distribution cavity and a filtering reactance cavity, at least one of the direct-current power distribution cavity, the alternating-current power distribution cavity and the filtering reactance cavity forming a circulation air duct together with the electronic cavity. The heat dissipation structure of an inverter improves the heat dissipation efficiency, reduces heat dissipation costs, and further improves the protection performance of the entire inverter.

## Description

The present application claims the priority to Chinese Patent Application No. 202323132153.5, titled "INVERTER AND HEAT DISSIPATION STRUCTURE THEREOF", filed on November 16, 2023 with the China National Intellectual Property Administration, which is incorporated herein by reference in its entirety.

### FIELD

The present application relates to the technical field of photovoltaic power generation and, in particular, to an inverter and a heat dissipation structure thereof.

### BACKGROUND

In grid-connected photovoltaic power generation systems, the inverter serves as the interface equipment connecting the photovoltaic power station to the power grid. The higher the power of the inverter, the lower the cost per watt, which is more conducive to achieving grid parity for photovoltaic power stations.

To enhance the power of the inverter, the components of the inverter are modularized to form multiple modular assemblies. These modular assemblies are independent of each other, and typically, each of the modular assemblies has its own independent heat dissipation system, which results in relatively high overall heat dissipation costs for the inverter.

At present, it is desired for those skilled in the art to design the heat dissipation arrangement for the modular assemblies of the inverter which can reduce the heat dissipation costs of the inverter.

### SUMMARY

In view of this, an object of the present application is to provide an inverter and a heat dissipation structure thereof, which can reduce heat dissipation costs of the inverter.

In order to achieve the above object, the following technical solutions are proposed according to the present application.

A heat dissipation structure for an inverter includes a first cabinet, a second cabinet, a liquid-cooling radiator, and a first liquid-cooling heat exchanger.

The first cabinet includes an electronic chamber, which is used for arranging the inverter power module section.

The liquid-cooling radiator is used for dissipating heat from a power module of the inverter power module section, and a coolant channel of the liquid-cooling radiator is in communication with a coolant channel of the first liquid-cooling heat exchanger.

The heat dissipation structure of the inverter is provided with a heat dissipation chamber, which is used for allowing air to flow through to cool the coolant in the first liquid-cooling heat exchanger.

The second cabinet includes a DC power distribution chamber, an AC power distribution chamber, and a filter reactor chamber. The DC power distribution chamber is used for arranging the DC power distribution section; the AC power distribution chamber is used for arranging the AC power distribution section; and the filter reactor chamber is used for arranging a reactor. A circulating air duct is formed by at least one of the DC power distribution chamber, the AC power distribution chamber and the filter reactor chamber, together with the electronic chamber.

Optionally, a second liquid-cooling heat exchanger for cooling the air is arranged within the circulating air duct.

Optionally, a coolant channel of the second liquid-cooling heat exchanger is connected to the coolant channel of the first liquid-cooling heat exchanger.

Optionally, the circulating air duct is formed by the DC power distribution chamber, the AC power distribution chamber, the filter reactor chamber, and the electronic chamber.

In the circulating air duct, the DC power distribution chamber, the AC power distribution chamber, and the electronic chamber are connected in series, and one of the DC power distribution chamber and the AC power distribution chamber is connected in parallel with the filter reactor chamber.

Optionally, the second liquid-cooling heat exchanger is located in the electronic chamber; and/or, the second liquid-cooling heat exchanger is located in the filter reactor chamber and in one of the DC power distribution chamber and the AC power distribution chamber that is connected in parallel with the filter reactor chamber.

Optionally, the circulating air duct is formed by the DC power distribution chamber, the AC power distribution chamber, the filter reactor chamber, and the electronic chamber.

In the circulating air duct, each of the DC power distribution chamber, the AC power distribution chamber, and the electronic chamber is connected in series with the filter reactor chamber, and the DC power distribution chamber and the AC power distribution chamber are connected in parallel.

Optionally, the second liquid-cooling heat exchanger is located in the electronic chamber, and/or the second liquid-cooling heat exchanger is located in the filter reactor chamber.

Optionally, the second liquid-cooling heat exchanger is located between devices in the electronic chamber and the reactor; and/or
both the first liquid-cooling heat exchanger and the second liquid-cooling heat exchanger are arranged in the first cabinet; and/or
both the first liquid-cooling heat exchanger and the second liquid-cooling heat exchanger are arranged in the second cabinet.

Optionally, the circulating air duct is formed by the DC power distribution chamber, the AC power distribution chamber, and the electronic chamber.

The filter reactor chamber is not in communication with the electronic chamber. A third liquid-cooling heat exchanger is arranged in the filter reactor chamber, and the third liquid-cooling heat exchanger is used for cooling the air in the filter reactor chamber.

Optionally, a coolant channel of the third liquid-cooling heat exchanger is in communication with the coolant channel of the first liquid-cooling heat exchanger.

Optionally, the circulating air duct is formed by one of the DC power distribution chamber and the AC power distribution chamber together with the electronic chamber. The other of the DC power distribution chamber and the AC power distribution chamber is not in communication with the electronic chamber, and the filter reactor chamber is not in communication with the electronic chamber.

A third liquid-cooling heat exchanger is arranged in the filter reactor chamber, and the third liquid-cooling heat exchanger is used for cooling the air in the filter reactor chamber.

A fourth liquid-cooling heat exchanger is provided in and configured to cool air in one of the DC power distribution chamber and the AC power distribution chamber that is not in communication with the electronic chamber.

Optionally, the coolant channel of the third liquid-cooling heat exchanger is in communication with the coolant channel of the first liquid-cooling heat exchanger, and a coolant channel of the fourth liquid-cooling heat exchanger is in communication with the coolant channel of the first liquid-cooling heat exchanger.

Optionally, the first cabinet and the second cabinet are sequentially distributed in the vertical direction; and/or
the DC power distribution chamber and the AC power distribution chamber are respectively located at opposite sides of the filter reactor chamber; and/or
the heat dissipation chamber is arranged on the first cabinet; and/or
the electronic chamber is also used for arranging a control circuit section.

Based on the above heat dissipation structure for an inverter, an inverter is further provided according to the present application. The inverter includes the heat dissipation structure for the inverter as described above.

Optionally, the inverter includes at least two inverter units.

Each of the inverter units includes the heat dissipation structure for the inverter as described above. Alternatively, each of the inverter units includes the first cabinet, the second cabinet, and the liquid-cooling radiator, and at least two of the inverter units share the first liquid-cooling heat exchanger and the heat dissipation chamber.

In the heat dissipation structure for the inverter provided according to the present application, the heat dissipation chamber is used to dissipate heat from the first liquid-cooling heat exchanger, achieving forced liquid cooling of the power modules, effectively improving heat dissipation efficiency, ensuring the protection requirements of the devices in the electronic chamber, and providing a prerequisite for the heat dissipation coupling between the electronic chamber and other chambers. Furthermore, the second cabinet includes a DC power distribution chamber, an AC power distribution chamber, and a filter reactor chamber, at least one of which, together with the electronic chamber, forms a circulating air duct, achieving the heat dissipation coupling between the devices in the electronic chamber and at least one of the DC power distribution section, the AC power distribution section, and the reactor. In this way, heat dissipation costs are reduced, compared with the separate heat dissipation of the first cabinet and the second cabinet (independent heat dissipation of each modular assembly) in the conventional technology.

### BRIEF DESCRIPTION OF THE DRAWINGS

In order to describe the technical solutions in the embodiments of the present application or in the conventional technology more clearly, the drawings for describing the embodiments or the conventional technology are briefly introduced hereinafter. Apparently, the drawings in the following description show merely the embodiments of the present application, and those skilled in the art can obtain other drawings based on these drawings without creative efforts.
FIG. 1 is a schematic structural view of a heat dissipation structure of an inverter according to a first embodiment of the present application;
FIG. 2 is a side view of the structure shown in FIG. 1;
FIG. 3 is a schematic structural view of variation of the heat dissipation structure of the inverter according to the first embodiment of the present application;
FIG. 4 is a side view of the structure shown in FIG. 3;
FIG. 5 is a schematic view showing a gas flow within a heat dissipation chamber of the heat dissipation structure of the inverter provided according to the first embodiment of the present application;
FIG. 6 is a schematic view showing another gas flow within the heat dissipation chamber of the heat dissipation structure of the inverter provided according to the first embodiment of the present application;
FIG. 7 is a schematic view showing another gas flow within the heat dissipation chamber of the heat dissipation structure of the inverter provided according to the first embodiment of the present application;
FIG. 8 is a schematic view showing another gas flow within the heat dissipation chamber of the heat dissipation structure of the inverter provided according to the first embodiment of the present application;
FIG. 9 is a schematic view showing another gas flow within the heat dissipation chamber of the heat dissipation structure of the inverter provided according to the first embodiment of the present application;
FIG. 10 is a schematic view showing another gas flow within the heat dissipation chamber of the heat dissipation structure of the inverter provided according to the first embodiment of the present application;
FIG. 11 is a schematic view showing air intake into a heat dissipation chamber of the heat dissipation structure of the inverter provided according to the first embodiment of the present application;
FIG. 12 is a schematic view showing a gas flow within a circulating air duct of the structure shown in FIG. 1;
FIG. 13 is a schematic structural view of variation of the heat dissipation structure of the inverter according to the first embodiment of the present application;
FIG. 14 is a schematic structural view of variation of the heat dissipation structure of the inverter according to the first embodiment of the present application;
FIG. 15 is a schematic structural view of a heat dissipation structure of an inverter according to a second embodiment of the present application;
FIG. 16 is a schematic view showing a gas flow within a circulating air duct of the structure shown in FIG. 15;
FIG. 17 is a schematic structural view of variation of the heat dissipation structure of the inverter according to the second embodiment of the present application;
FIG. 18 is a schematic structural view of variation of the heat dissipation structure of the inverter according to the second embodiment of the present application; and
FIG. 19 is a schematic structural view of a heat dissipation structure of an inverter according to a third embodiment of the present application.

Description of reference numerals in the drawings:
100 first cabinet; 200 second cabinet; 101 heat dissipation chamber; 102 electronic chamber; 201 DC power distribution chamber; 202 AC power distribution chamber; 203 filter reactor chamber; 1 first liquid-cooling heat exchanger; 2 first fan; 3 circulation pump; 4 storage tank; 5 liquid-cooling radiator; 6 DC power distribution section; 7 AC power distribution section; 8 reactor; 9 connecting channel; 10 second liquid-cooling heat exchanger; 11 second fan; 12 third fan; 13 partition plate; 14 fourth fan; 15 third liquid-cooling heat exchanger.

### DETAILED DESCRIPTION OF THE EMBODIMENTS

Hereinafter, technical solutions in embodiments of the present application will be described clearly and completely with reference to the drawings showing the embodiments of the present application. Apparently, the described embodiments are only some rather than all embodiments of the present application. Based on the embodiments of the present application, all other embodiments obtained by those skilled in the art without any creative work fall into the protection scope of the present application.

Technical solutions according to embodiments of the present application will be described clearly and completely as follows with reference to the accompany drawings showing the embodiments of the present application. The terminologies used in the following embodiments are only for the purpose of describing specific embodiments, and are not intended to limit the present application. As used in the specification and appended claims of the present application, the singular expressions "a", "one", "said", "the above", "the" and "this" are intended to include expressions such as "one or more", unless otherwise indicated clearly in the context. It should also be understood that, in the embodiment of the present application, the expression "one or more" refers to one, two or more; the expression "and/or" describes an association relationship of related objects and indicates three possible relationships. For example, A and/or B may indicate three cases: A alone, A and B, and B alone. In each case, the number of A may be one or more, and the number of B may be one or more. The symbol "/" generally indicates an "or" relationship between the objects it connects.

In this specification, references to "an embodiment", "some embodiments" or the like mean that a particular feature, structure, or characteristic described in connection with the embodiment(s) is included in one or more embodiments of the present application. Thus, phrases such as "in an embodiment", "in some embodiments", "in some other embodiments" and "in yet other embodiments" etc., appearing in different places in this specification do not necessarily all refer to the same embodiment(s). Rather, they mean "one or more, but not all embodiments" unless otherwise specifically emphasized. The terms "comprising", "including", "having" and variations thereof mean "including, but not limited to" unless otherwise specifically emphasized.

The term "multiple or a plurality of" in the embodiment of the present application refers to two or more. It should be noted that, in the description of the embodiments of the present application, words such as "first" and "second" are only used for the purpose of distinguishing descriptions, and cannot be understood as indicating or implying relative importance, nor can they be understood as indicating or implying order.

An inverter mainly includes a DC power distribution section, an inverter power module section, an AC filtering section, an AC power distribution section, a control circuit section, etc.

In the inverter, both the inverter power module section and the control circuit section may be considered as part of a first modular assembly, and the DC power distribution section, the AC filtering section, and the AC power distribution section may be considered as part of a second modular assembly. The first modular assembly is typically arranged in the first cabinet, and the second modular assembly is arranged in the second cabinet, with the first and second cabinets being relatively independent.

It should be noted that both the first and second modular assemblies may be used independently and may be interchanged between different inverters, and may also be used outdoors, if necessary. The inverter may further include other modular assemblies, not limited to the first and second modular assemblies mentioned above.

The first and second cabinets dissipate heat independently, meaning that the first and second modular assemblies dissipate heat independently, resulting in high overall heat dissipation costs for the inverter.

Furthermore, the chamber, in which the reactor of the AC filtering section is located, is communicated with the external environment of the inverter, meaning that the reactor is in direct contact with the air outside of the inverter, resulting in a low protection level for the chamber in which the reactor is located.

In view of the aforementioned issues, an inverter and a heat dissipation structure thereof are provided according to embodiments of the present application, which can reduce the heat dissipation costs of the inverter.

Based on the functions, physical dimensions, heat generation characteristics, and inherent protection levels of the various components of the inverter (the DC power distribution section, the inverter power module section, the AC filtering section, the AC power distribution section, and the control circuit section), the heat dissipation structure of the inverter is reasonably designed and optimized. Four embodiments are provided below to specifically illustrate the heat dissipation structure of the inverter provided according to the embodiments of the present application.

### First Embodiment.

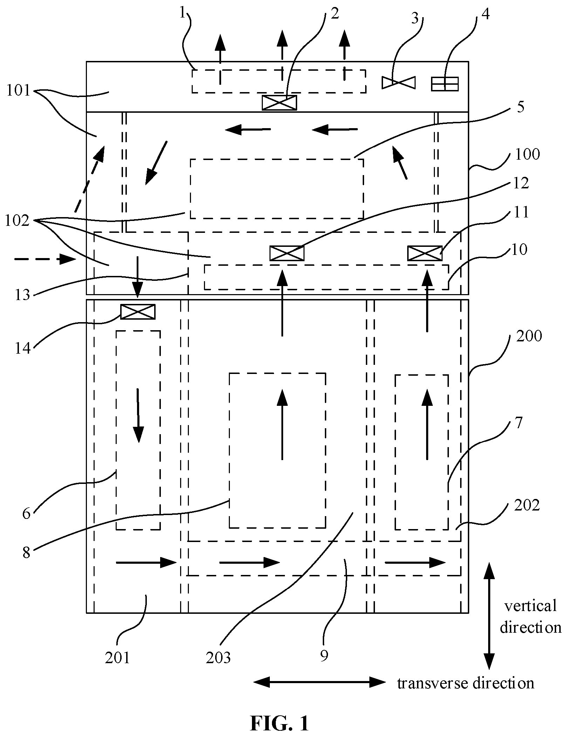

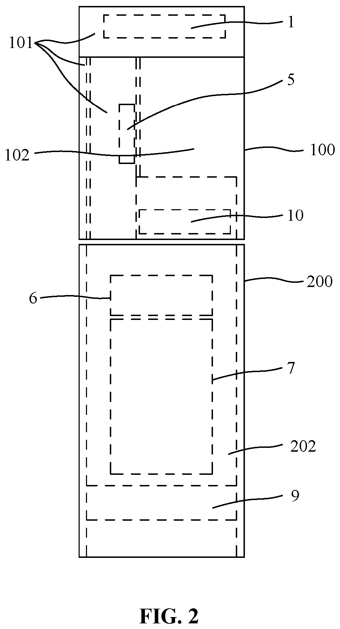

As shown in FIGS. 1 and 2, the heat dissipation structure of the inverter provided according to the first embodiment includes a first cabinet 100, a second cabinet 200, a liquid-cooling radiator, and a first liquid-cooling heat exchanger.

In this embodiment, the first cabinet 100 is located at the top of the second cabinet 200. The second cabinet 200 and the first cabinet 100 may be sequentially distributed from bottom to top in a vertical direction. In actual situations, the first cabinet 100 and the second cabinet 200 may be arranged in any other manner. For example, the second cabinet 200 and the first cabinet 100 may be sequentially distributed from top to bottom in the vertical direction or sequentially distributed in a direction other than the vertical direction, which is not limited in the first embodiment.

The first cabinet 100 includes a heat dissipation chamber 101 and an electronic chamber 102. The heat dissipation chamber 101 and the electronic chamber 102 may be arranged based on actual circumstances, which is not limited in the first embodiment.

The aforementioned electronic chamber 102 is used to house devices such as the inverter power module section and the control circuit section. It may be understood that the inverter power module section includes an inverter module. It should be noted that the devices inside the electronic chamber 102 are not shown in FIGS. 1 and 2. The aforementioned control circuit section may also be arranged in the second cabinet 200, which is not limited to be in the electronic chamber 102.

The power modules of the inverter power module section generate a large amount of heat, and the heat is relatively concentrated. To meet the heat dissipation requirements of the power modules, the liquid-cooling radiator 5 is used to dissipate heat from the power modules. It may be understood that the liquid-cooling radiator 5 contains coolant, which is used to dissipate heat from the power modules. The coolant may be water or any other liquid, which is not limited in the first embodiment.

The aforementioned power modules are provided on the liquid-cooling radiator 5. As heat is dissipated from the power modules, the coolant in the liquid-cooling radiator 5 may be heated up, resulting in need of cooling of the coolant in the liquid-cooling radiator 5. Based on this, coolant channels of the first liquid-cooling heat exchanger 1 and the liquid-cooling radiator 5 are in communication.

To achieve reuse of the coolant, the coolant circulates between the first liquid-cooling heat exchanger 1 and the liquid-cooling radiator. Based on this, the heat dissipation structure of the aforementioned inverter further includes a circulation pump 3 that drives the coolant to circulate between the first liquid-cooling heat exchanger 1 and the liquid-cooling radiator 5.

To facilitate the replenishment of the coolant, the heat dissipation structure of the aforementioned inverter further includes a storage tank 4, which is used to store the coolant. In this case, the circulation pump 3 is also used to communicate the storage tank 4 and the first liquid-cooling heat exchanger 1. It may be understood that the circulation pump 3 is also used to drive the coolant to flow between the storage tank 4 and the first liquid-cooling heat exchanger 1.

The heat dissipation chamber 101 is used for air to flow through to cool the first liquid-cooling heat exchanger 1, that is, the heat dissipation chamber 101 is used for air to flow through to cool the coolant inside the first liquid-cooling heat exchanger 1. It may be understood that the air entering the heat dissipation chamber 101 is the air coming from outside the heat dissipation chamber 101, e.g., the air outside the entire inverter, or the air coming from a chamber of the inverter rather than the heat dissipation chamber 101, as long as the cooling effect is achieved.

In FIG. 1, the dashed arrows in the heat dissipation chamber 101 indicate the direction of airflow within the heat dissipation chamber 101. The direction shown by these dashed arrows is only approximate and illustrative, which is not absolute.

The aforementioned first liquid-cooling heat exchanger 1 is located in the heat dissipation chamber 101, or the chamber in which the first liquid-cooling heat exchanger 1 is located is in communication with the heat dissipation chamber 101.

The aforementioned heat dissipation chamber 101 is located in the first cabinet 100. To enhance the protection level of the electronic chamber 102, the heat dissipation chamber 101 and the electronic chamber 102 may be relatively isolated, resulting in different protection levels for the heat dissipation chamber 101 and the electronic chamber 102, specifically, the protection level of the electronic chamber 102 being higher than that of the heat dissipation chamber 101. Here, the heat dissipation chamber 101 may be referred to as a low-protection chamber, and the electronic chamber 102 may be referred to as a high-protection chamber.

In practical situations, the heat dissipation chamber 101 may be arranged outside the first cabinet 100, or inside the second cabinet 200, or outside the second cabinet 200, or in any other cabinet of the inverter, which is not limited in this embodiment.

The liquid-cooling radiator 5 is arranged in the first cabinet 100, for example, in the electronic chamber 102 or the heat dissipation chamber 101. To ensure that the air flowing through the heat dissipation chamber 101 cools the coolant in the first liquid-cooling heat exchanger 1, the first liquid-cooling heat exchanger 1 of the liquid cooling system is arranged in the heat dissipation chamber 101. The air flowing through the heat dissipation chamber 101 passes through the first liquid-cooling heat exchanger 1 to cool the coolant inside the first liquid-cooling heat exchanger 1, thereby cooling the coolant in the radiator of the power module, i.e., cooling the aforementioned liquid-cooling radiator 5. This further enhances the protection performance of the electronic chamber 102.

The first liquid-cooling heat exchanger 1 may be arranged at any other position, e.g., in the electronic chamber 102, which is not limited to the aforementioned embodiment. It may be understood that the first liquid-cooling heat exchanger 1 and the heat dissipation chamber 101 are arranged in the same cabinet (the first cabinet 100 or the second cabinet 200).

To improve the protection performance of the electronic chamber 102, both the circulation pump 3 and the storage tank 4 are arranged in the heat dissipation chamber 101. The circulation pump 3 and the storage tank 4 may be arranged at any other position in the inverter, e.g., both within the electronic chamber 102, which is not limited in the first embodiment.

To facilitate maintenance of the first liquid-cooling heat exchanger 1, the circulation pump 3, and the storage tank 4, they may all be arranged at the top of the heat dissipation chamber 101. Specifically, they may all be arranged at the top of the first cabinet 100. The first liquid-cooling heat exchanger 1, the circulation pump 3, and the storage tank 4 may be arranged at any other position in the first cabinet 100, which is not limited in the first embodiment.

In the aforementioned structure, utilizing the heat dissipation chamber 101 to dissipate heat from the first liquid-cooling heat exchanger 1 enables forced liquid cooling of the power module, effectively improving heat dissipation efficiency. It also facilitates meeting the protection requirements for devices in the electronic chamber 102 and provides a prerequisite for heat dissipation coupling between the electronic chamber 102 and other chambers (a DC power distribution chamber 201, an AC power distribution chamber 202, and a filtering reactor chamber 203).

To facilitate airflow through the heat dissipation chamber 101, a first fan 2 is provided inside the heat dissipation chamber 101. To ensure that the air flowing through the heat dissipation chamber 101 passes through the first liquid-cooling heat exchanger 1, the first fan 2 may be arranged at the air inlet or outlet side of the first liquid-cooling heat exchanger 1. The first fan 2 may be arranged at any other position, which is not limited in the first embodiment.

To facilitate maintenance, the first fan 2 may be located at the top of the heat dissipation chamber 101, that is, at the top of the first cabinet 100. The first fan 2 may be located at any other position, which is not limited in this embodiment.

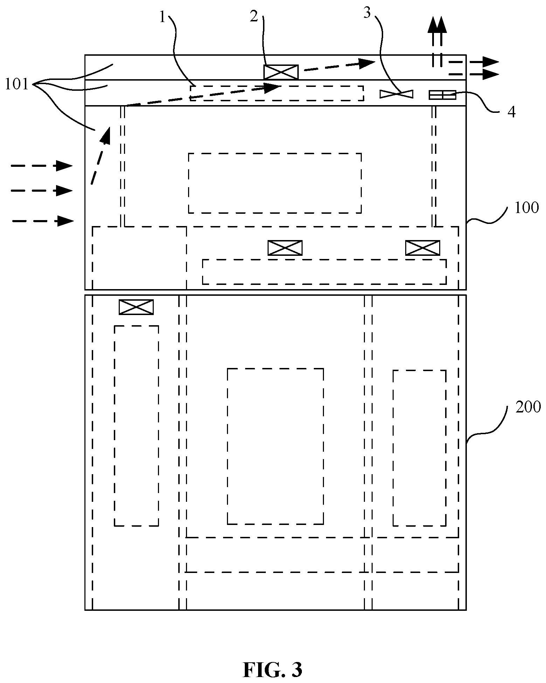

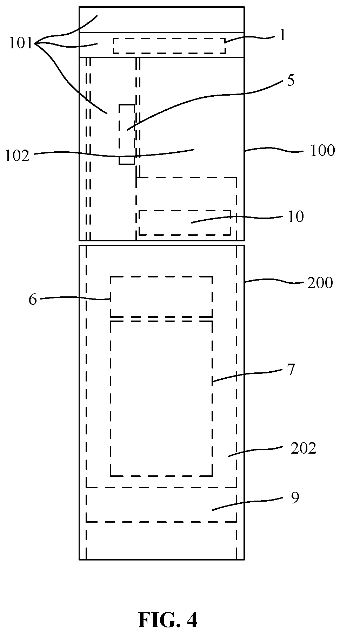

As shown in FIGS. 3 and 4, in a case that the first liquid-cooling heat exchanger 1, the circulation pump 3, and the storage tank 4 are all located at the top of the first cabinet 100, and the first fan 2 is also located at the top of the first cabinet 100, the first fan 2 may be arranged on top of the first liquid-cooling heat exchanger 1. This facilitates maintenance of the first fan 2 and avoids damage to the first fan 2 caused by leakage from the first liquid-cooling heat exchanger 1.

In this embodiment, the heat dissipation chamber 101 has an air inlet and an air outlet. The air inlet and the air outlet may be arranged in various manners, which will be explained in detail below.

On the one hand, as shown in FIG. 1, the air inlet of the heat dissipation chamber 101 is provided at the left side (which may be referred to as the front side) of the first cabinet 100, and the air outlet of the heat dissipation chamber 101 is provided at the top side of the first cabinet 100. In this case, the IP protection level requirement for the first fan 2 is relatively high.

On the other hand, as shown in FIG. 3, the heat dissipation chamber 101 has at least one air inlet provided at the left side of the first cabinet 100, at least one air outlet provided at the top side of the first cabinet 100 near the right side, and at least one air outlet provided at the right side of the first cabinet 100 and being higher than the air inlet(s) of the heat dissipation chamber 101.

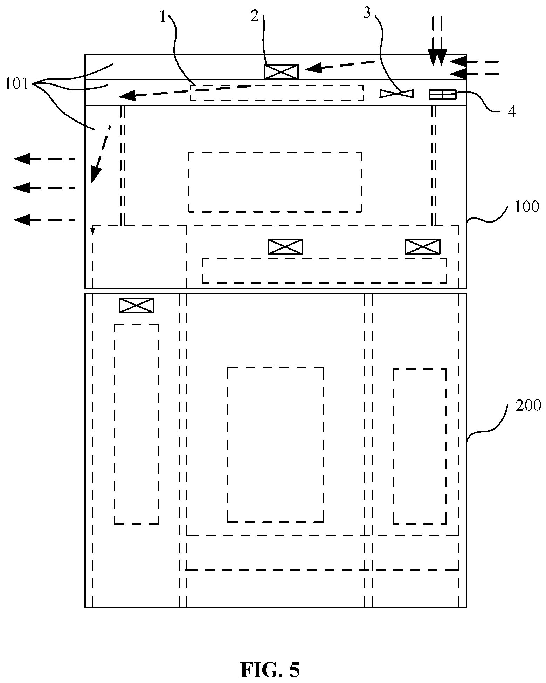

In FIG. 3, the positions of the air inlet and the air outlet of the heat dissipation chamber 101 may be interchanged to arrive at the structure shown in FIG. 5.

It should be noted that, if the air inlet or the air outlet of the heat dissipation chamber 101 is distributed on the top surface of the first cabinet 100, the IP protection level requirement for the first fan 2 is relatively high.

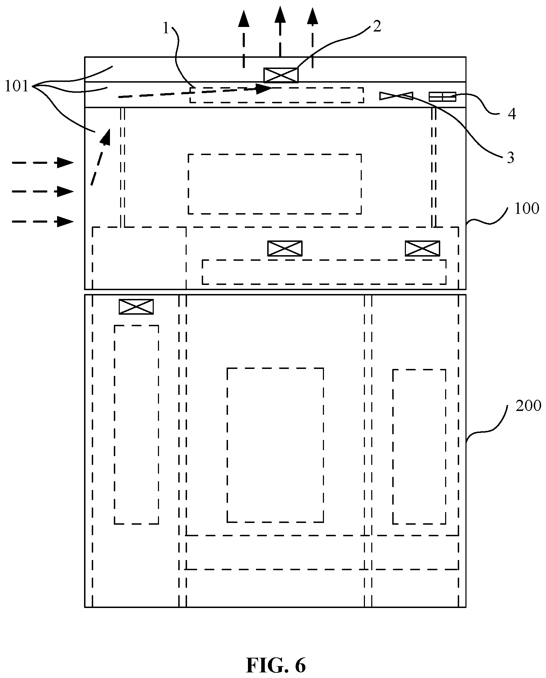

As shown in FIG. 6, the air outlet of the heat dissipation chamber 101 is only located on the top surface of the first cabinet 100. For example, the air outlet of the heat dissipation chamber 101 is arranged in the middle of the top surface of the first cabinet 100. In this case, the air inlet of the heat dissipation chamber 101 is provided on the front and/or rear sides of the first cabinet 100.

It should be noted that the front and rear sides of the first cabinet 100 are opposite to each other, and are both provided with cabinet doors. The front and rear sides of the first cabinet 100 are the opposite sides in its transverse direction.

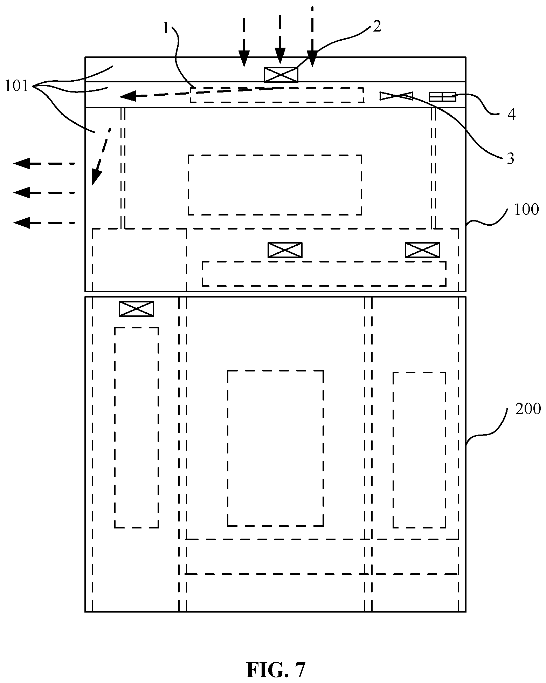

The positions of the air inlet and the air outlet of the heat dissipation chamber 101 in FIG. 6 may be interchanged to arrive at the structure shown in FIG 7.

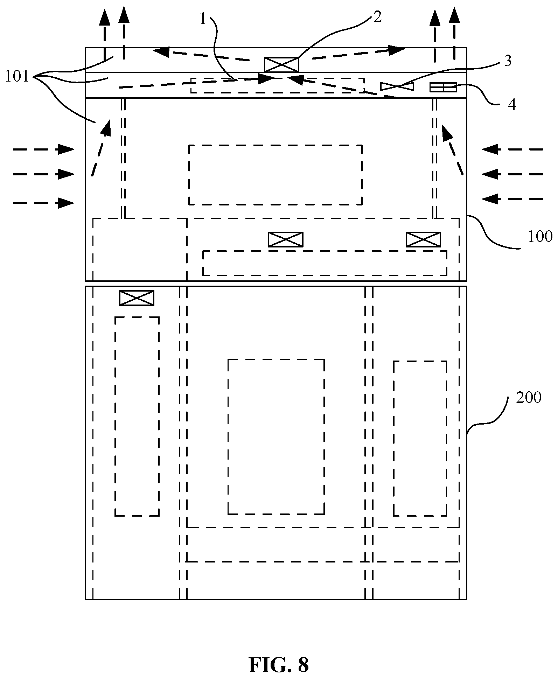

As shown in FIG. 8, the heat dissipation chamber 101 has at least one air inlet located on the front side of the first cabinet 100, at least one air inlet located on the rear side of the first cabinet 100, and at least two air outlets of the heat dissipation chamber 101 located on the top side of the first cabinet 100. At least one of the air outlets is arranged on the top surface of the first cabinet 100 near the front side, and at least one of the air outlets is arranged on the top surface of the first cabinet 100 near the rear side. In this way, the number of the air inlets and the air outlets of the heat dissipation chamber 101 is increased, effectively improving the ventilation volume of the heat dissipation chamber 101, which is conducive to enhancing the heat dissipation effect and efficiency.

It should be noted that the number of the air inlets and the air outlets of the heat dissipation chamber 101 in the above embodiment may be varied depending on actual conditions.

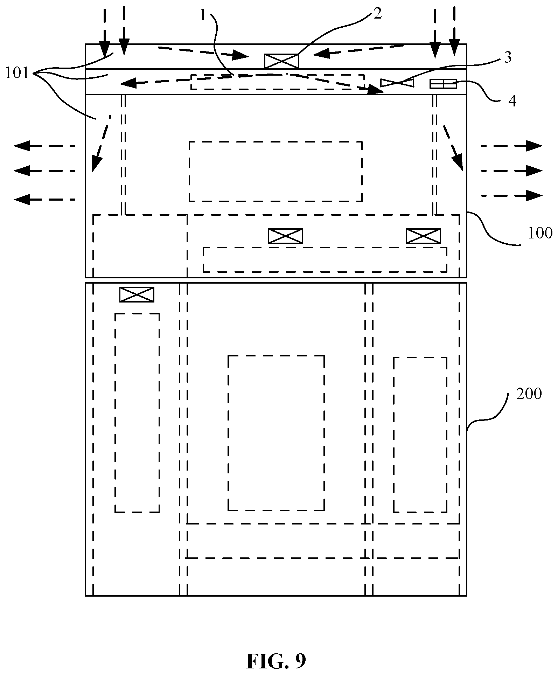

The positions of the air inlets and the air outlets of the heat dissipation chamber 101 in FIG. 8 may be interchanged to arrive at the structure shown in FIG. 9.

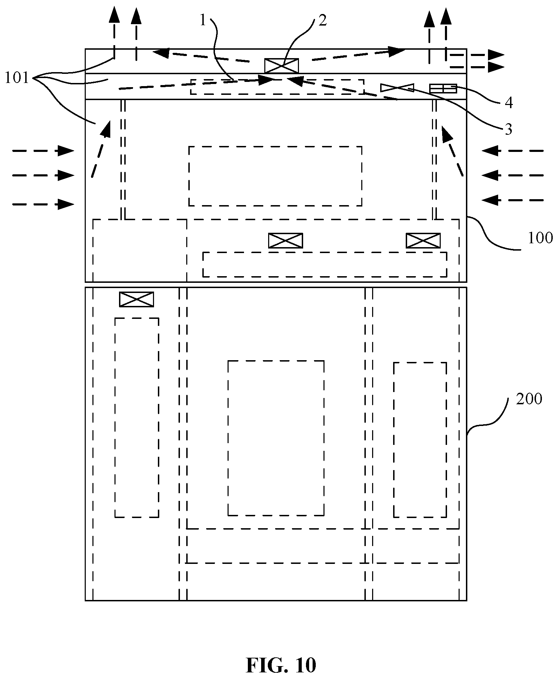

On the basis of FIG. 8, additional air outlets may be provided. As shown in FIG. 10, on the basis of the structure shown in FIG. 8, at least one additional air outlet is provided on the rear side of the first cabinet 100.

It should be noted that the positions of the air inlets and the air outlets of the heat dissipation chamber 101 in FIG. 10 may be interchanged.

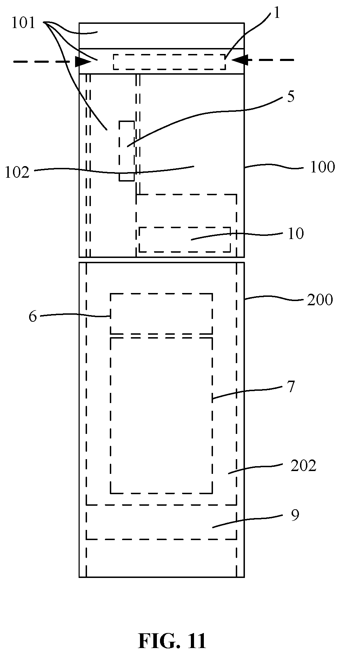

The air inlets and the air outlets of the above-mentioned heat dissipation chamber 101 may also be arranged at other positions, which is not limited to the left, right, and top sides mentioned earlier. As shown in FIG. 11, at least one air inlet of the heat dissipation chamber 101 is located on a first side of the first cabinet 100, and at least one air inlet of the heat dissipation chamber 101 is located on a second side of the first cabinet 100. It can be understood that the first and second sides of the first cabinet 100 are between the front and rear sides of the first cabinet 100. This effectively increases the air inlet volume of the heat dissipation chamber 101, which is beneficial for improving the heat dissipation effect and efficiency.

The air inlets shown in FIG. 11 may also be arranged only on the first side or the second side of the first cabinet 100, and the air inlet manner is not limited to that shown in FIG. 11.

It is also possible to arrange at least one air outlet of the heat dissipation chamber 101 on the first side and/or the second side of the first cabinet 100. This effectively increases the air outlet volume of the heat dissipation chamber 101, which is beneficial for improving the heat dissipation effect and efficiency.

It should be noted that the location of the second air outlet may be the location of the air inlet in FIG. 11.

In actual situations, the air inlets of the above-mentioned heat dissipation chamber 101 may be arranged only on the first side and/or the second side of the first cabinet 100, or the air outlets of the heat dissipation chamber 101 may be arranged only on the first side and/or the second side of the first cabinet 100.

In some embodiments, to avoid mutual interference between the air inlet and outlet of the heat dissipation chamber 101, the air inlets and the air outlets of the heat dissipation chamber 101 may be arranged on different sides of the first cabinet 100. For example, the air inlets and the air outlets of the heat dissipation chamber 101 are located on opposite sides of the heat dissipation chamber 101. It is also possible to arrange the air inlets and the air outlets of the heat dissipation chamber 101 on the same side of the first cabinet 100, which is not limited to the above-mentioned structure.

The number of the air inlets and the air outlets of the heat dissipation chamber 101 may be determined depending on actual conditions, which is not limited in the first embodiment.

The above-mentioned second cabinet 200 includes a DC power distribution chamber 201, an AC power distribution chamber 202, and a filter reactor chamber 203. The DC power distribution chamber 201 is used to house the DC power distribution section 6. The AC power distribution chamber 202 is used to house the AC power distribution section 7. The filter reactor chamber 203 is used to house the reactor 8.

The above-mentioned DC power distribution chamber 201 and AC power distribution chamber 202 are respectively located on both sides of the filter reactor chamber 203, that is, the filter reactor chamber 203 is located between the DC power distribution chamber 201 and the AC power distribution chamber 202. As such, a copper busbar connection path in the entire inverter may be minimized, leading to better cost-effectiveness.

It should be noted that the positions of the DC power distribution chamber 201 and the AC power distribution chamber 202 may be interchanged.

It is possible to arrange the DC power distribution chamber 201 and the AC power distribution chamber 202 on the same side of the filter reactor chamber 203. For example, in FIG. 1, both the DC power distribution chamber 201 and the AC power distribution chamber 202 are located on the left side of the filter reactor chamber 203, and the DC power distribution chamber 201 and the AC power distribution chamber 202 may be arranged sequentially either in the transverse direction or in the longitudinal direction. The transverse and longitudinal directions are perpendicular to each other, and the transverse and longitudinal directions both are perpendicular to the vertical direction, which is the height direction of the second cabinet 200.

Since the DC power distribution section 6, the AC power distribution section 7, and the devices in the electronic chamber 102 (e.g., the power modules and control circuit sections) have relatively low protection levels, the top of each of the DC power distribution chamber 201, the AC power distribution chamber 202, and the filter reactor chamber 203 may be in communication with the electronic chamber 102, and the bottoms of any two of the DC power distribution chamber 201, the filter reactor chamber 203, and the AC power distribution chamber 202 may be in communication. In this way, the DC power distribution chamber 201, the AC power distribution chamber 202, the filter reactor chamber 203, and the electronic chamber 102 form a circulating air duct. The solid arrows in FIG. 1 indicate the direction of air flow in the circulating air duct, and the direction shown by these solid arrows is only approximate and illustrative, which is not absolute.

To improve protection performance and heat dissipation effect, the above-mentioned circulating air duct may be configured to be a closed air duct that is not communicated with the external environment. In actual situations, it is also possible to communicate the circulating air duct to the external environment, as long as the air inside the circulating air duct flows in a determined direction.

In the above structure, the heat dissipation of each of the DC power distribution section 6, the AC power distribution section 7, and the reactor 8 is coupled with that of the devices in the electronic chamber 102. Compared with the conventional technology where the first cabinet and the second cabinet are separately cooled (each modular assembly is independently cooled), the heat dissipation costs are reduced. Moreover, the devices in the electronic chamber 102, the DC power distribution section 6, the AC power distribution section 7, and the reactor 8 are all arranged in a closed circulating air duct. It can be understood that the DC power distribution chamber 201, the AC power distribution chamber 202, the filter reactor chamber 203, and the electronic chamber 102 are all high-protection chambers. Thus, the protection requirements of the devices in the electronic chamber 102, the DC power distribution section 6, the AC power distribution section 7, and the reactor 8 can be ensured, thereby improving the protection reliability of the entire inverter. It should be noted that the heat dissipation chamber 101 may be referred to as a low-protection chamber.

Furthermore, in the above structure, the air in the circulating air duct may dissipate heat from the power modules, and the air in the heat dissipation chamber 101 may also dissipate heat from the power modules, achieving dual heat dissipation for the power modules and effectively improving the heat dissipation efficiency and effect of the power modules.

As shown in FIG. 1, to facilitate formation of a circulating air duct by the DC power distribution chamber 201, the AC power distribution chamber 202, the filter reactor chamber 203, and the electronic chamber 102, air outlets are provided at the top of both the filter reactor chamber 203 and the AC power distribution chamber 202, and the air inlet is provided at the top of the DC power distribution chamber 201. The air outlets of the filter reactor chamber 203 and the AC power distribution chamber 202 are both in communication with the air inlet of the electronic chamber 102, and the air outlet of the electronic chamber 102 is in communication with the air inlet of the DC power distribution chamber 201. Both the air inlet and outlet of the electronic chamber 102 are located at the bottom of the electronic chamber 102.

To ensure the formation of the circulating air duct, a partition plate 13 is provided in the electronic chamber 102, isolating the air inlet from the air outlet of the electronic chamber 102. This prevents short-circuiting of the air duct in the electronic chamber 102, thereby ensuring the formation of the circulating air duct.

In the above structure, the bottom of the DC power distribution chamber 201, the bottom of the filter reactor chamber 203, and the bottom of the AC power distribution chamber 202 are sequentially in communication through a connecting channel 9. The connecting channel 9 is located at the bottom of the second cabinet 200. The connecting channel 9 is located in the filter reactor chamber 203, or in both the filter reactor chamber 203 and the AC power distribution chamber 202. The connecting channel 9 is part of the circulating air duct.

In the above circulating air duct, air flowing out of the DC power distribution chamber 201 splits into two parts, with one part entering the filter reactor chamber 203 and the other part entering the AC power distribution chamber 202. Air flowing out of the filter reactor chamber 203 and air flowing out of the AC power distribution chamber 202 converge within the electronic chamber 102 and then enter the DC power distribution chamber 201 after flowing through the electronic chamber 102.

In the above circulating air duct, the AC power distribution chamber 202 and the filter reactor chamber 203 are arranged in parallel, and the DC power distribution chamber 201, the AC power distribution chamber 202, and the electronic chamber 102 are arranged in series. That is to say, with respect to the circulating air duct, the air duct of the AC power distribution chamber 202 and the air duct of the filter reactor chamber 203 are arranged in parallel, and the air duct of the DC power distribution chamber 201, the air duct of the AC power distribution chamber 202, and the air duct of the electronic chamber 102 are arranged in series. In actual situations, the positions of the air duct of the AC power distribution chamber 202 and the air duct of the DC power distribution chamber 201 may be interchanged, so that the air duct of the DC power distribution chamber 201 and the air duct of the filter reactor chamber 203 are arranged in parallel, and the air duct of the DC power distribution chamber 201, the air duct of the AC power distribution chamber 202, and the air duct of the electronic chamber 102 are arranged in series. In this way, air flowing out of the AC power distribution chamber 202 splits into two parts, with one part entering the filter reactor chamber 203 and the other part entering the DC power distribution chamber 201; and air flowing out of the filter reactor chamber 203 and the air flowing out of the DC power distribution chamber 201 converge within the electronic chamber 102 and then enter the AC power distribution chamber 202 after flowing through the electronic chamber 102.

Since a circulating air duct is formed by the DC power distribution chamber 201, the AC power distribution chamber 202, the filter reactor chamber 203, and the electronic chamber 102, the air within the circulating air duct is gradually heated up. To ensure the normal operation of the devices within the circulating air duct, it is necessary to cool the air within the circulating air duct. To this end, a second liquid-cooling heat exchanger 10 is provided within the first cabinet 100 to cool the air within the circulating air duct. The second liquid-cooling heat exchanger 10 is located between the devices within the electronic chamber 102 and the reactor 8.

As shown in FIG. 1, the second liquid-cooling heat exchanger 10 may be arranged at the air inlet of the electronic chamber 102. In this way, air flowing out of the filter reactor chamber 203 and the AC power distribution chamber 202 is cooled by the second liquid-cooling heat exchanger 10 before flowing through the electronic chamber 102. This allows the cold air to firstly cool the devices within the electronic chamber 102, improving the cooling effect and efficiency for the devices within the electronic chamber 102. This configuration is particularly suitable for the case where the devices within the electronic chamber 102 generate a significant amount of heat or are resistant to low temperatures.

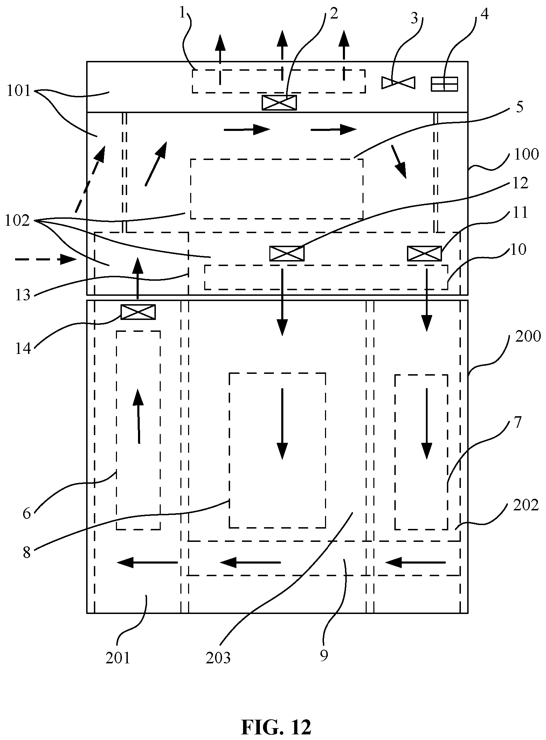

When the reactor 8 generates a significant amount of heat or is resistant to low temperatures, the reactor 8 may be firstly cooled by cold air. To this end, the direction of air flow within the circulating air duct may be adjusted. As shown in FIG. 12, the direction of air flow within the circulating air duct is completely reverse to that shown in FIG. 1. In this case, air flowing out of the electronic chamber 102 is cooled by the second liquid-cooling heat exchanger 10 before flowing through the filter reactor chamber 203 and the AC power distribution chamber 202. This allows the cold air to firstly cool the reactor 8 and the AC power distribution section 7, improving the cooling effect and efficiency for the reactor 8 and the AC power distribution section 7.

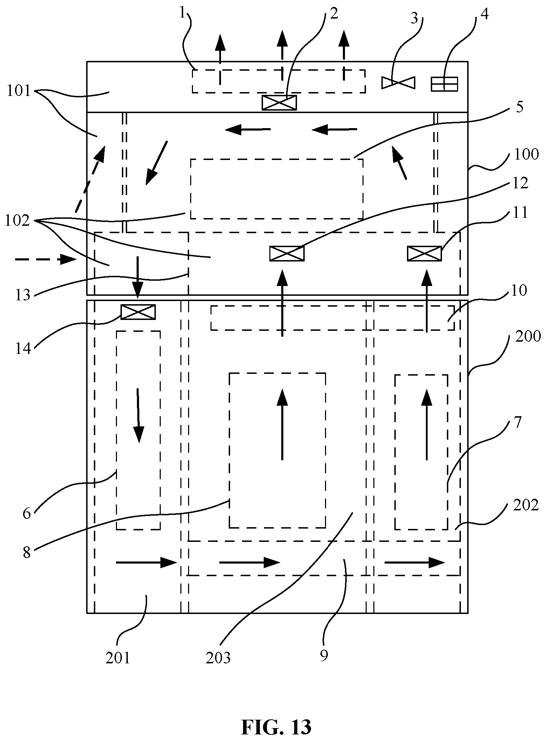

In the first embodiment, the second liquid-cooling heat exchanger 10 may also be placed at any other position. As shown in FIG. 13, the second liquid-cooling heat exchanger 10 may be arranged within the second cabinet 200. That is, the second cabinet 200 is provided with the second liquid-cooling heat exchanger 10, which is located within the AC power distribution chamber 202 and the filter reactor chamber 203. This reduces the number of devices within the first cabinet 100, thereby reducing its weight and facilitating its handling, which in turn facilitates the maintenance of the devices within the first cabinet 100.

In the above structure, to facilitate the placement of the second liquid-cooling heat exchanger 10, the second liquid-cooling heat exchanger 10 may be located at the top of the reactor 8 and the AC power distribution section 7.

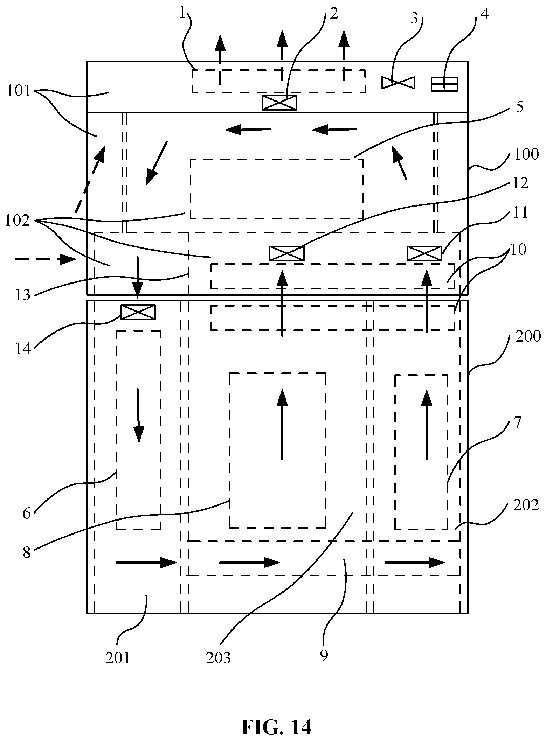

As shown in FIG. 14, both the first cabinet 100 and the second cabinet 200 are provided with the second liquid-cooling heat exchanger 10. The second liquid-cooling heat exchanger 10 within the second cabinet 200 is located in the AC power distribution chamber 202 and the filter reactor chamber 203 at the top of the reactor 8 and the AC power distribution section 7. The second liquid-cooling heat exchanger 10 within the first cabinet 100 is located in the electronic chamber 102 at the bottom of the devices within the electronic chamber 102. This increases the heat exchange area, improving the cooling efficiency and effect for the devices within the circulating air duct. This configuration is particularly suitable for the case where the devices within the electronic chamber 102 generate a significant amount of heat.

To facilitate air flow within the circulating air duct and to adjust the direction of air flow within the circulating air duct, a fan is provided within the circulating air duct. The number and distribution of the fans may be determined depending on actual conditions. For example, a second fan 11, a third fan 12, and a fourth fan 14 may be provided in the circulating air duct. The second fan 11 is placed within the electronic chamber 102 at the air vent of the electronic chamber 102, and faces the air vent of the AC power distribution chamber 202. The third fan 12 is placed within the electronic chamber 102 at the air vent of the electronic chamber 102, and faces the air vent of the filter reactor chamber 203. The fourth fan 14 is placed within the DC power distribution chamber 201 at the air vent of the DC power distribution chamber 201, and faces the air vent of the electronic chamber 102. Both the second fan 11 and the third fan 12 are located at the air inlet or outlet side of the second liquid-cooling heat exchanger 10.

Since the first liquid-cooling heat exchanger 1 is placed within the heat dissipation chamber 101, and the air flowing through the heat dissipation chamber 101 cools the coolant within the first liquid-cooling heat exchanger 1, to reduce heat dissipation costs, the coolant channel of the first liquid-cooling heat exchanger 1 may be in communication with the coolant channel of the second liquid-cooling heat exchanger 10. In this case, the circulation pump 3 is also used to drive the coolant to circulate between the first liquid-cooling heat exchanger 1 and the second liquid-cooling heat exchanger 10. The coolant channel of the second liquid-cooling heat exchanger 10 may be arranged in parallel or in series with the coolant channel of the liquid-cooling radiator 5, depending on actual conditions, which is not limited in this embodiment.

In the above structure, the liquid-cooling radiator 5 and the second liquid-cooling heat exchanger 10 share the heat dissipation chamber 101 and the first liquid-cooling heat exchanger 1. In a case that the heat dissipation structure of the inverter includes a circulation pump 3 and a storage tank 4, the liquid-cooling radiator 5 and the second liquid-cooling heat exchanger 10 also share the circulation pump 3 and the storage tank 4. As a result, all the chambers of the inverter are arranged in the same liquid-cooling heat dissipation system, reducing the number of devices required to cool the coolant, and effectively reducing heat dissipation costs. It also reduces space occupation, helping to reduce the volumes of the first cabinet 100 and the second cabinet 200. Compared with air cooling, it effectively improves the heat dissipation effect and efficiency.

It is also possible to provide an additional device to cool the coolant within the second liquid-cooling heat exchanger 10, which is not limited to the above embodiment.

In this embodiment, the liquid-cooling radiator 5, the first liquid-cooling heat exchanger 1, and the second liquid-cooling heat exchanger 10 are all air-liquid heat exchangers, which have coolant channels and air channels for heat exchange. The coolant channels allow the coolant to flow through, and the air channels allow the air to flow through.

In other embodiments, the air-liquid heat exchanger may only have a coolant channel for passage of the coolant, and the outer surface of the air-liquid heat exchanger is capable of heat exchange with the coolant channel. In this case, the air directly flows over the outer surface of the air-liquid heat exchanger to cool the coolant within the coolant channel.

In the first embodiment, there is at least one first liquid-cooling heat exchanger 1 and at least one second liquid-cooling heat exchanger 10. The number and distribution of the first liquid-cooling heat exchanger 1 and the second liquid-cooling heat exchanger 10 may be determined depending on actual conditions, which is not limited in the first embodiment.

### Second Embodiment

The heat dissipation structure of the inverter provided in the second embodiment differs from that in the first embodiment mainly in different circulating air ducts and different positions of the second liquid-cooling heat exchanger 10.

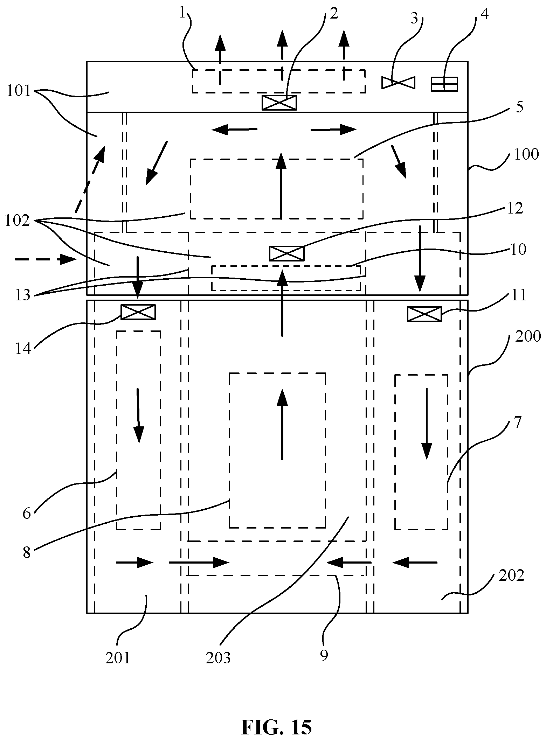

As shown in FIG. 15, in the second embodiment, the air outlet of the filter reactor chamber 203 is in communication with the air inlet of the electronic chamber 102. The air inlets of both the DC power distribution chamber 201 and the AC power distribution chamber 202 are in communication with the air outlets of the electronic chamber 102. The air outlets of both the DC power distribution chamber 201 and the AC power distribution chamber 202 are in communication with the air inlet of the filter reactor chamber 203 through the connecting channel 9. A partition plate 13 is provided within the electronic chamber to separate the air inlet from the air outlet of the electronic chamber 102, ensuring the formation of a circulating air duct.

It should be noted that, in the circulating air duct, the DC power distribution chamber 201, the AC power distribution chamber 202, and the electronic chamber 102 are all connected in series with the filter reactor chamber 203, and the DC power distribution chamber 201 and the AC power distribution chamber 202 are connected in parallel. That is to say, with respect to the circulating air duct, the air ducts of the DC power distribution chamber 201, the AC power distribution chamber 202, and the electronic chamber 102 are all connected in series with the air duct of the filter reactor chamber 203, and the air ducts of the DC power distribution chamber 201 and the AC power distribution chamber 202 are connected in parallel.

In the second embodiment, the second liquid-cooling heat exchanger 10 is arranged within the first cabinet 100 between the devices in the electronic chamber 102 and the reactor 8.

In the above structure, the second liquid-cooling heat exchanger 10 is located at the air inlet of the electronic chamber 102 and at the bottom of the devices within the electronic chamber 102. Thus, the air flowing out from the filter reactor chamber 203 is cooled by the second liquid-cooling heat exchanger 10 before entering the electronic chamber 102. The air is then divided into two parts, with one part entering the DC power distribution chamber 201 and the other part entering the AC power distribution chamber 202. The air flowing out from the DC power distribution chamber 201 and the air flowing out from the AC power distribution chamber 202 both enter the connecting channel 9 and converge before entering the filter reactor chamber 203 from the connecting channel 9. In this way, the air cooled by the second liquid-cooling heat exchanger 10 firstly cools the devices within the electronic chamber 102, which is particularly suitable for situations where the devices in the electronic chamber 102 generate a large amount of heat or are resistant to low temperatures.

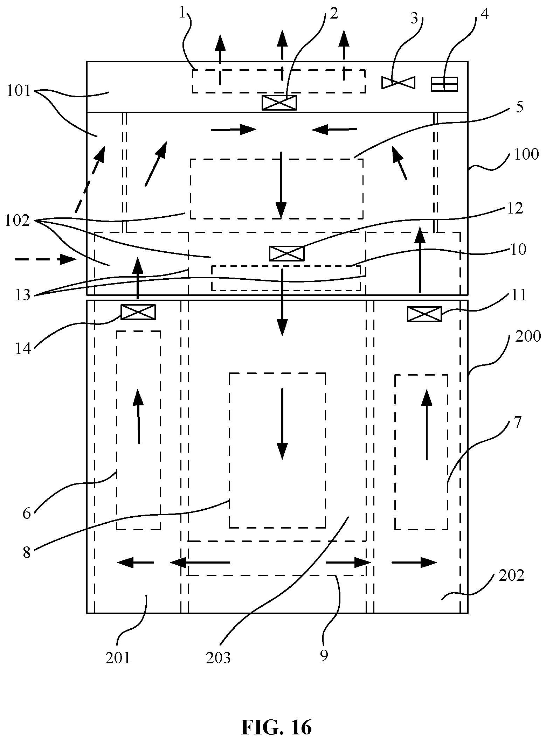

When the reactor 8 generates a large amount of heat or is resistant to low temperatures, the reactor 8 may be firstly cooled by cold air. To this end, the direction of air flow within the circulating air duct may be adjusted. As shown in FIG. 16, the direction of air flow within the circulating air duct is completely reverse to that shown in FIG. 15. In this way, the air flows out from the electronic chamber 102 after cooled by the second liquid-cooling heat exchanger 10 and flows through the filter reactor chamber 203. Thus, cold air firstly cools the reactor 8, improving the cooling effect and efficiency for the reactor 8.

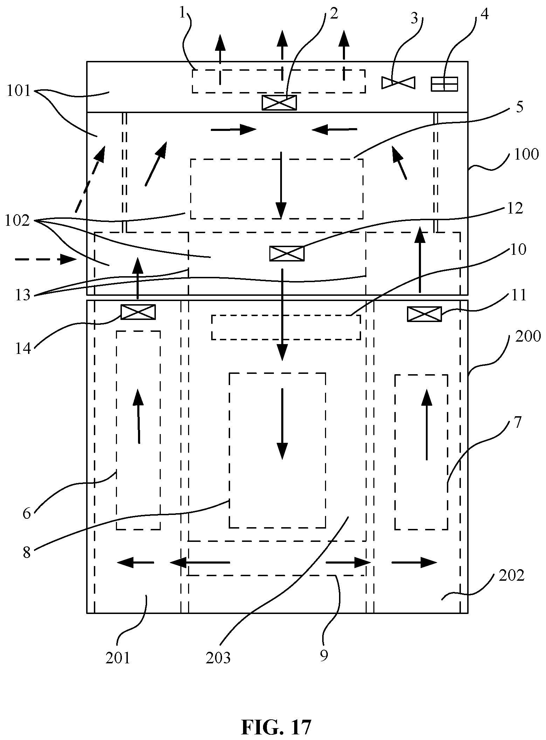

In the second embodiment, the second liquid-cooling heat exchanger 10 may be provided at any other position. As shown in FIG. 17, the second liquid-cooling heat exchanger 10 is provided within the second cabinet 200 and located in the filter reactor chamber 203. This reduces the number of devices within the first cabinet 100, thereby reducing the weight of the first cabinet 100 and facilitating its handling and the maintenance of the devices within the first cabinet 100.

In the above structure, to facilitate the mounting of the second liquid-cooling heat exchanger 10, the second liquid-cooling heat exchanger 10 may be arranged at the top of the reactor 8.

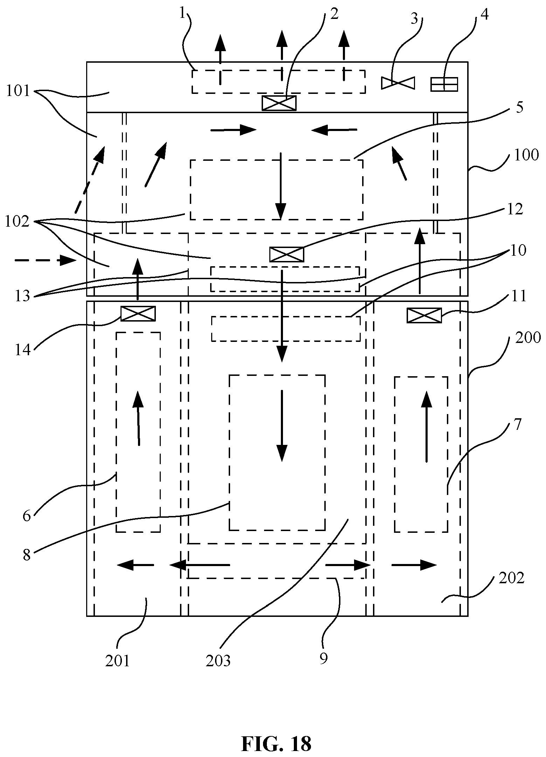

As shown in FIG. 18, both the first cabinet 100 and the second cabinet 200 are provided with second liquid-cooling heat exchangers 10. The second liquid-cooling heat exchanger 10 in the second cabinet 200 is located in the filter reactor chamber 203 at the top of the reactor 8, and the second liquid-cooling heat exchanger 10 in the first cabinet 100 is located in the electronic chamber 102 at the bottom of the devices within the electronic chamber 102. This increases the heat exchange area and improves the cooling efficiency and effect for the devices within the circulating air duct. This structure is particularly suitable for situations where the devices in the electronic chamber 102 generate a large amount of heat.

To facilitate air flow within the circulating air duct and adjust the direction of air flow within the circulating air duct, a fan is provided within the circulating air duct. The number and distribution of the fans may be determined based on actual conditions. For example, a second fan 11, a third fan 12, and a fourth fan 14 may be provided in the circulating air duct. The second fan 11 is provided in the AC power distribution chamber 202 and located at its air vent, facing the air vent of the electronic chamber 102. The third fan 12 is provided in the electronic chamber 102 and located at its air vent, facing the air vent of the filter reactor chamber 203. The fourth fan 14 is provided in the DC power distribution chamber 201 and located at its air vent, facing the air vent of the electronic chamber 102. The third fan 12 is located at either the air inlet side or the air outlet side of the second liquid-cooling heat exchanger 10.

For other structures of the heat dissipation structure of the inverter in the second embodiment, reference may be made to the first embodiment, and details are not described here.

### Third Embodiment

The heat dissipation structure of the inverter provided in the third embodiment differs from that in the first embodiment mainly in different circulating air ducts.

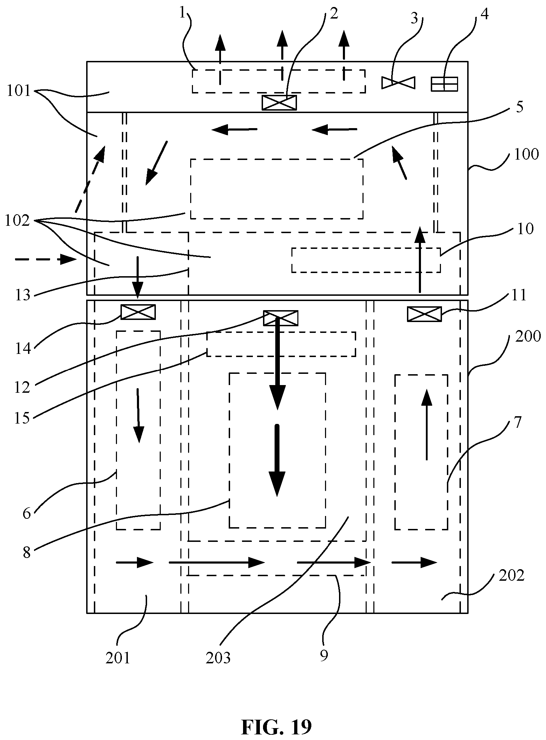

The reactor 8 generates a large amount of heat. If the reactor 8 is placed in the same circulating air duct as devices such as capacitors and AC/DC switches, the heat generated from the reactor 8 may cause the temperature rise of these devices. The maximum temperature resistance of the reactor 8 is much higher than that of the devices such as capacitors and AC/DC switches. Therefore, it is necessary to cool the reactor 8 separately. For this purpose, as shown in FIG. 19, the filter reactor chamber 203 is not in communication with the electronic chamber 102, i.e., the filter reactor chamber 203 is not in communication with the circulating air duct. For example, the DC power distribution chamber 201, the AC power distribution chamber 202, and the electronic chamber 102 are all not in communication with the filter reactor chamber 203. Based on this, the filter reactor chamber 203 may be configured as a closed chamber.

In this third embodiment, a third liquid-cooling heat exchanger 15 is provided within the filter reactor chamber 203. For the specific structure of the third liquid-cooling heat exchanger 15, reference may be made to the structure of the air-liquid heat exchanger in the first embodiment.

The air within the filter reactor chamber 203 is disturbed, and the coolant within the third liquid-cooling heat exchanger 15 cools the air flowing around it, thereby cooling the reactor 8. The bold solid arrows in FIG. 19 indicate the approximate and illustrative direction of air disturbance within the filter reactor chamber 203, which is not absolute.

The specific position of the third liquid-cooling heat exchanger 15 within the filter reactor chamber 203 may be determined based on actual conditions and is not limited in this embodiment.

To facilitate air disturbance within the filter reactor chamber 203, the filter reactor chamber 203 is provided therein with a third fan 12. The number and location of the third fans 12 may be determined based on actual conditions and are not limited in this embodiment.

In the third embodiment, since the filter reactor chamber 203 is not in communication with the circulating air duct, the reactor 8 does not affect the cooling of the devices within the circulating air duct. Moreover, cooling the reactor 8 separately improves its cooling effect and efficiency.

In the third embodiment, since the filter reactor chamber 203 is not in communication with the circulating air duct, the circulating air duct is formed by the DC power distribution chamber 201, the AC power distribution chamber 202, and the electronic chamber 102. As shown in FIG. 19, the DC power distribution chamber 201, the AC power distribution chamber 202, and the electronic chamber 102 are sequentially connected end-to-end to form the circulating air duct. The top of the DC power distribution chamber 201 and the top of the AC power distribution chamber 202 are both in communication with the bottom of the electronic chamber 102, and the bottom of the DC power distribution chamber 201 is in communication with the bottom of the AC power distribution chamber 202 through the connecting channel 9. The connecting channel 9 may be provided within the filter reactor chamber 203, that is, the connecting channel 9 is provided within the second cabinet 200.

The thin solid arrows in FIG. 19 indicate the approximate and illustrative direction of air flow within the circulating air duct, which is not absolute.

A copper busbar may be provided in the AC power distribution chamber 202, and connected to the low-voltage side of the transformer. To facilitate mounting and heat dissipation, the copper busbar is positioned at the bottom of the AC power distribution chamber 202. In this way, air flowing out from the connection channel 9 can pass over the copper busbar to dissipate heat from it.

The number and position of the second liquid-cooling heat exchanger 10 in the circulating air duct, as well as the number and position of the fans in the circulating air duct, may be designed with reference to the preceding description and in consideration of actual circumstances, which is not limited in this embodiment.

The second liquid-cooling heat exchanger 10 and/or the third liquid-cooling heat exchanger 15 may share the heat dissipation chamber 101 and the first liquid-cooling heat exchanger 1. It may be understood that the coolant channel of the second liquid-cooling heat exchanger 10 is in communication with the coolant channel of the first liquid-cooling heat exchanger 1, and/or the coolant channel of the third liquid-cooling heat exchanger 15 is in communication with the coolant channel of the first liquid-cooling heat exchanger 1. In other words, the coolant within the second liquid-cooling heat exchanger 10 and/or the third liquid-cooling heat exchanger 15 is cooled through the heat dissipation chamber 101 by the first liquid-cooling heat exchanger 1. This arrangement reduces the number of components, lowers the cost of the inverter, and helps to reduce the volume of the inverter, especially in a case that both the second liquid-cooling heat exchanger 10 and the third liquid-cooling heat exchanger 15 share the heat dissipation chamber 101 and the first liquid-cooling heat exchanger 1.

The coolant channels through which coolant flows in the second liquid-cooling heat exchanger 10 and the third liquid-cooling heat exchanger 15 may be arranged in parallel or in series, depending on actual circumstances, which is not limited in this embodiment.

The second liquid-cooling heat exchanger 10 and the third liquid-cooling heat exchanger 15 may be equipped with devices for cooling the coolant, which is not limited to the above embodiment.

For the other structures of the heat dissipation structure of the inverter in the third embodiment, reference may be made to the first embodiment, and details are not described here.

### Fourth Embodiment

The main difference between the heat dissipation structure of the inverter provided in the fourth embodiment and that in the third embodiment lies in the different circulating air ducts.

In the fourth embodiment, a circulating air duct is formed by the electronic chamber 102 and one of the DC power distribution chamber 201 and the AC power distribution chamber 202, and the other of the DC power distribution chamber 201 and the AC power distribution chamber 202 is not in communication with the electronic chamber 102. It may be understood that the one of the DC power distribution chamber 201 and the AC power distribution chamber 202 that does not communicate with the electronic chamber 102 is not in communication with the circulating air duct either.

The one of the DC power distribution chamber 201 and the AC power distribution chamber 202 which is not in communication with the electronic chamber 102 is provided therein with a fan for agitating air therein and a fourth liquid-cooling heat exchanger for cooling the air and thus cooling the devices therein.

For the specific structure of the fourth liquid-cooling heat exchanger, reference may be made to the structure of the air-liquid heat exchanger in the first embodiment. For cooling of the coolant in the fourth liquid-cooling heat exchanger, reference may be made to the third liquid-cooling heat exchanger, and details are not described in this fourth embodiment.

In a case that the coolant channel of the third liquid-cooling heat exchanger 15 is in communication with the coolant channel of the first liquid-cooling heat exchanger 1, and the coolant channel of the fourth liquid-cooling heat exchanger is in communication with the coolant channel of the first liquid-cooling heat exchanger 1, the coolant channel of the third liquid-cooling heat exchanger 15 and the coolant channel of the fourth liquid-cooling heat exchanger may be arranged in parallel or in series.

For the other structures of the heat dissipation structure of the inverter in this fourth embodiment, reference may be made to the above description, which is not repeated here.

Based on the heat dissipation structure of the inverter provided in the above embodiments, an inverter is further provided according to the embodiments of the present application. The inverter includes the heat dissipation structure of the inverter provided in the above embodiments.

In view of the technical effects bringing about by the heat dissipation structure of the inverter provided in the above embodiments, the inverter including the same also has corresponding technical effects, which are not repeated here.

In some embodiments, the inverter includes at least one inverter unit.

In a case that the inverter includes a single inverter unit:
the inverter unit may include the heat dissipation structure of the inverter provided in the above embodiments, or
the inverter unit may include a first cabinet 100, a second cabinet 200, and a liquid-cooling radiator 5, exclusive of the first liquid-cooling heat exchanger 1 and the heat dissipation chamber 101. In this case, the first liquid-cooling heat exchanger 1 and the heat dissipation chamber 101 are provided separately as independent units. This simplifies the structure of the inverter unit and reduces its volume and cost; and also simplifies the structure of the entire inverter and reduces its volume and cost.

In a case that the inverter includes at least two inverter units:
each of the inverter units may include the heat dissipation structure of the inverter provided in the above embodiments, or
each of the inverter units may include a first cabinet 100, a second cabinet 200, and a liquid-cooling radiator 5, and at least two inverter units share the first liquid-cooling heat exchanger 1 and the heat dissipation chamber 101. It may be understood that the inverter unit does not include the first liquid-cooling heat exchanger 1 and the heat dissipation chamber 101. This simplifies the structure of the inverter units and reduces its volume and cost; and also simplifies the structure of the entire inverter and reduces its volume and cost.

In the case that a second liquid-cooling heat exchanger 10 is provided in the circulating air duct, the inverter unit further includes the second liquid-cooling heat exchanger 10. In a case that a third liquid-cooling heat exchanger 15 is provided in the filter reactor chamber 203, the inverter unit further includes the third liquid-cooling heat exchanger 15. In a case that a fourth liquid-cooling heat exchanger is provided in one of the DC power distribution chamber 201 and the AC power distribution chamber 202 that is not in communication with the electronic chamber 102, the inverter unit further includes the fourth liquid-cooling heat exchanger.

The type of the aforementioned inverter may be selected based on actual circumstances. For example, the inverter may be a photovoltaic grid-connected inverter, which is not limited in the present application.

Based on the above description of the disclosed embodiments, those skilled in the art are capable of implementing or using the present application. It is apparent for those skilled in the art to make many modifications to these embodiments. The general principle defined herein may be applied to other embodiments without departing from the scope of the present application. Therefore, the present application should not be limited to the embodiments disclosed herein, but has the widest scope in accordance to the concept and the novel features disclosed herein.

## Claims

1. A heat dissipation structure for an inverter, **characterized in that** the heat dissipation structure comprises a first cabinet, a second cabinet, a liquid-cooling radiator, a first liquid-cooling heat exchanger, and a heat dissipation chamber, wherein
the first cabinet comprises an electronic chamber, which is configured to arrange an inverter power module section;
the liquid-cooling radiator is configured to dissipate heat from a power module of the inverter power module section, and has a coolant channel communicated with a coolant channel of the first liquid-cooling heat exchanger;
the heat dissipation chamber is configured to allow passage of air so as to cool coolant in the first liquid-cooling heat exchanger; and
the second cabinet comprises a DC power distribution chamber, an AC power distribution chamber, and a filter reactor chamber, wherein the DC power distribution chamber is configured to arrange a DC power distribution section, the AC power distribution chamber is configured to arrange an AC power distribution section, the filter reactor chamber is configured to arrange a reactor, and a circulating air duct is formed by the electronic chamber and at least one of the DC power distribution chamber, the AC power distribution chamber and the filter reactor chamber.

2. The heat dissipation structure for the inverter according to claim 1, wherein a second liquid-cooling heat exchanger for cooling air is arranged within the circulating air duct.

3. The heat dissipation structure for the inverter according to claim 2, wherein a coolant channel of the second liquid-cooling heat exchanger is in communication with the coolant channel of the first liquid-cooling heat exchanger.

4. The heat dissipation structure for the inverter according to claim 2, wherein the circulating air duct is formed by the DC power distribution chamber, the AC power distribution chamber, the filter reactor chamber, and the electronic chamber; and
in the circulating air duct, the DC power distribution chamber, the AC power distribution chamber, and the electronic chamber are connected in series, and one of the DC power distribution chamber and the AC power distribution chamber is connected in parallel with the filter reactor chamber.

5. The heat dissipation structure for the inverter according to claim 4, wherein
the second liquid-cooling heat exchanger is located in the electronic chamber; and/or
the second liquid-cooling heat exchanger is located in the filter reactor chamber and in the one of the DC power distribution chamber and the AC power distribution chamber that is connected in parallel with the filter reactor chamber.

6. The heat dissipation structure for the inverter according to claim 2, wherein the circulating air duct is formed by the DC power distribution chamber, the AC power distribution chamber, the filter reactor chamber, and the electronic chamber; and
in the circulating air duct, each of the DC power distribution chamber, the AC power distribution chamber, and the electronic chamber is connected in series with the filter reactor chamber, and the DC power distribution chamber and the AC power distribution chamber are connected in parallel.

7. The heat dissipation structure for the inverter according to claim 6, wherein the second liquid-cooling heat exchanger is located in the electronic chamber; and/or
the second liquid-cooling heat exchanger is located in the filter reactor chamber.

8. The heat dissipation structure for the inverter according to any one of claims 2 to 7, wherein the second liquid-cooling heat exchanger is located between devices in the electronic chamber and the reactor; and/or
both the first liquid-cooling heat exchanger and the second liquid-cooling heat exchanger are arranged in the first cabinet; and/or
both the first liquid-cooling heat exchanger and the second liquid-cooling heat exchanger are arranged in the second cabinet.

9. The heat dissipation structure for the inverter according to claim 1, wherein
the circulating air duct is formed by the DC power distribution chamber, the AC power distribution chamber, and the electronic chamber; and
the filter reactor chamber is not in communication with the electronic chamber, and a third liquid-cooling heat exchanger is arranged in the filter reactor chamber, and is configured to cool air in the filter reactor chamber.

10. The heat dissipation structure for the inverter according to claim 9, wherein a coolant channel of the third liquid-cooling heat exchanger is in communication with the coolant channel of the first liquid-cooling heat exchanger.

11. The heat dissipation structure for the inverter according to claim 1, wherein
the circulating air duct is formed by the electronic chamber and one of the DC power distribution chamber and the AC power distribution chamber, the other of the DC power distribution chamber and the AC power distribution chamber is not in communication with the electronic chamber, and the filter reactor chamber is not in communication with the electronic chamber;
a third liquid-cooling heat exchanger is arranged in the filter reactor chamber, and is configured to cool air in the filter reactor chamber; and
a fourth liquid-cooling heat exchanger is provided in and configured to cool air in the other of the DC power distribution chamber and the AC power distribution chamber that is not in communication with the electronic chamber.

12. The heat dissipation structure for the inverter according to claim 11, wherein a coolant channel of the third liquid-cooling heat exchanger is in communication with the coolant channel of the first liquid-cooling heat exchanger, and a coolant channel of the fourth liquid-cooling heat exchanger is in communication with the coolant channel of the first liquid-cooling heat exchanger.

13. The heat dissipation structure for the inverter according to any one of claims 1 to 12, wherein the first cabinet and the second cabinet are sequentially distributed in a vertical direction; and/or
the DC power distribution chamber and the AC power distribution chamber are respectively located at opposite sides of the filter reactor chamber; and/or
the heat dissipation chamber is arranged in the first cabinet; and/or
the electronic chamber is further configured to arrange a control circuit section.

14. An inverter, **characterized by** comprising the heat dissipation structure for the inverter according to any one of claims 1 to 13.

15. The inverter according to claim 14, comprising at least two inverter units, wherein
each of the inverter units comprises the heat dissipation structure for the inverter according to any one of claims 1 to 13; or
each of the inverter units comprises the first cabinet, the second cabinet, and the liquid-cooling radiator, and at least two of the inverter units share the first liquid-cooling heat exchanger and the heat dissipation chamber.
